# EUROPEAN PATENT SPECIFICATION

(11) **EP 1 567 633 B1**
(45) Date of publication and mention of the grant of the patent: **24.08.2011**
(21) Application number: 03810398.2
(22) Date of filing: 10.10.2003
(51) Int. Cl.: C11D 7/06, C11D 7/32, C11D 3/39, H01L 21/306

(54) **SEMICONDUCTOR SURFACE TREATMENT AND MIXTURE USED THEREIN**
HALBLEITEROBERFLÄCHENBEHANDLUNG UND DABEI VERWENDETE MISCHUNG
TRAITEMENT DE LA SURFACE D'UN SEMI-CONDUCTEUR ET MELANGE DE NETTOYAGE ASSOCIE

(30) Priority: 05.11.2002 EP 02024675
(43) Date of publication of application: 31.08.2005
(73) Proprietor: BASF SE, 67056 Ludwigshafen (DE)
(72) Inventor: BÖRNER, Marc, 64283 Darmstadt (DE); KILIAN, Gernod, 60431 Frankfurt am Main (DE); RHEIN, Rudolf, 64646 Heppenheim (DE); ARNOLD, Lucia, 64839 Münster (DE); SCHUSTER, Michael, 85435 Erding (DE); LEOPOLD, Alexander, 85748 Garching (DE)
(86) International application number: PCT/EP2003/011254
(87) International publication number: WO 2004/041989

(56) References cited:
- EP-A- 1 091 395
- WO-A-99/60448
- FR-A- 2 816 528
- US-A- 5 290 361
- US-A- 5 962 384
- US-B1- 6 228 823

## Description

### Technical Field

The present invention relates to a surface treatment composition and a method for treating the surface of a substrate using the same. More particularly, the present invention relates to a surface treatment composition comprising a liquid medium as a main component, which prevents a substrate surface from being contaminated with metal impurities from the surface treatment composition and stably provides an extremely clean substrate surface, and also relates to a method for treating the surface of a substrate by using the same.

### Background Art

Further miniaturization by rapid ultra high integration of LSI (large-scale integration) the wet cleaning process is strongly required to improve its performance and reduce its cost. There is an important need for strict contamination control, because trace impurities have detrimental effects on the properties and can severely degrade yield of devices. Many new ideas were explored in concept of reducing the cleaning process cost, processing time, promote environmental responsibility, reducing chemicals and waste handling.

A standard wet cleaning sequence have been widely used based on RCA cleaning method (RCA Rev. 31, p. 187, 1970 [1]). The standard RCA was designed to remove particulates as well as organic and metallic impurities from silicon surfaces. The chemistry used in this cleaning sequence is a combination of two different chemistries: SC-1 and SC-2 (Standard Clean 1 and 2). The first cleaning step, SC-1 (also called APM), is comprised of ammonium hydroxide, hydrogen peroxide and DI water. Particles and remaining organics are removed by oxidative dissolution. In a second step, SC-2 (also called HPM); a mixture of hydrochloric acid, hydrogen peroxide and DI water is used to remove any residual metals from the semiconductor surface.

So theorie, while many drawbacks of each RCA-step during cleaning treatment occurs (Handbook of semiconductor wafer cleaning technology, (W. Kern, ed.) p-3-56 (1993) [2]; Mat. Res. Soc. Symp. Proc. Vol. 477 (1997) [3]; J. Electrochem. Soc. Vol. 141 (10), p. 139 (1994) [4]). Most of the cleaning solution exhibit good efficiency just for one type of contaminant. So a further major problem results (often) in re-contamination on silicon substrates under mentioned chemistries. Hiratsuka et al. showed pH dependence of metal deposition onto silicon substrates. Especially Fe, Zn and Al get easily deposited as hydroxides in alkali solutions (Ultra Clean Technology, Vol.3 (3), p. 258 (1993) [5]). Decreasing of silicon surfaces roughness by micromasking in aqueous peroxide solution shows another problem ([2]; J. Electrochem. Soc. 147 (2), p. 736, 2000 [6]).

In order to avoid these problems, various cleaning modifications have been employed different in treating chemicals, temperature, etc. to increase bath lifetime and efficiency. For example, Heyns et al. proposed a cleaning recipe without ammonia or hydrochloric acid (Mater. Res. Soc. Symp. Proc., p. 35 (1993) [7]). Different approaches use ozone and / or HF based cleanings with /without megasonics to improve cleaning procedure: European Patent Nos. EP0,994,505A2 [8] and 0,982,765A2 [9]; Solid State Technology (July), p. 109 (1995) [10]; J. Electrochem, Soc. 148 (3), p 118 (2001) [11]; J. Electrochem. Soc. 148 (5), p. 241 (2001) [12]; Mat. Res. Soc. Symp. Proc. Vol. 477, p. 35 (1997) [13].

Injection of complexing or chelating agents could simplified the total cleaning procedure The efficiency of chelating agents in preventing metals from adhering onto silicon surfaces in cleaning solutions has been shown in a number of patents and literature, e.g., European Patent Nos. EP1047121A1 [14], EP0496605B1 [15], EP0986096A2 [16], EP1091395A1 [17], EP0560324 [18], EP652283A1 [19], U.S.Patent Nos. US5962384 [20], US5290361 [21], US5837667 [22], Japanese Patent Unexamined Puplication No. 50147284 [23]; J. Electrochem. Soc. 148 (6), p.G315 (2001) [24], Solid State Phenomena Vols. 76-77, p. 119 (2001) [25]; Proc. Electrochem. Soc. 99-36, p. 114 (2000) [26], Solid State Phenomena Vols. 65-66, p. 23 (1999) [27].

The above references disclose the use of many complexing agents such as EDTA, CDTA (acetic acid compounds), alkanolamine (e.g. TEA), specific compounds having phosphonic acid or hydroxam groups (e.g. Dequest 2060, cTRAMP, Desferal), alkylammonium hydroxids (e.g. TMAH) or phenols (catechol, Tiron).

Laboratories explore/attempt to design chelating agents capable of complexing multi charged metal ions (e.g. Fe, Ca, Zn, Ni, Al) in cleaning solutions and acting as stabilizer for H₂O₂ and / or SC-1. Another important object of the chelating agent should be the removal of metallic contaminats on silicon substrates. Most of the additives are less able to work in multiple functions or present no sufficient complex-stability during cleaning treatment. Therefore many complexing agents are not applicable in industrial cleaning process. For example, EDTA is not significantly active in the SC-1 solution in comparison to the mentioned phosphonic acid compounds because of its decomposition under elevated temperatur treatment. APM solutions containing phosphonic acid groups show less efficiency in removing Al from the silicon surface. Also the stability constant of Al-chelate (EDTA) complex at SC-1 treatment (pH 9-10) is by far lower than that of other metals. Dequest 2060 and .cTRAMP exhibit good complexing behaviour, especially for Fe (Zn and Cu), during 10 minutes cleaning steps. Saloniemi et al. (VTT Electronics) and U.S. Patent US5962384 [28] support good results of CDTA in suppressing H₂O₂ decomposition in diluted APM solution and decreasing metal deposition on Si-substrates except of aluminum. Also good results using at least two chelating agents in preventing metal deposition on Si-substrates are stated by Morinaga et al. in U.S Patent US6,228,823B1 [29] and [3].

### Aims of the Invention

It is therefore an object of the present invention to improve the stability of above mentioned cleaning solution containing aqueous hydrogen peroxide and ammonia (APM) at normal temperature and especially at elevated temperature. A further object of the present invention is to provide a cleaning solution which is free of phosphate compounds.

Still another aim of the invention is to present a modified cleaning method which can effectively be used as a single step alkaline cleaning method for silicon surfaces.

### Disclosure of the invention

The present invention relates to a cleaning solution, which is capable to remove and inhibit metal contaminations from a surface of a semiconductor substrate. Also, it relates to a cleaning solution, which shows inhibiting properties against new metal contamination on said surfaces during the cleaning process.

As a result of experiments a recipe and a cleaning mixture is developed for preventing metal impurities from being deposited onto silicon surfaces. In special it has been found that the addition of a chelating agent makes it possible to prepare said cleaning mixtures free of phosphor containing compounds.

The present invention further includes a cleaning solution capable to remove metal contamination from surfaces of semiconductor substrates.

A third advantageous feature of the present invention is a considerable improvement of the stability of the above mentioned cleaning solutions containing aqueous hydrogen peroxide and ammonia (APM).

The selected chelating agents may be added to the cleaning solution directly before use, but a preferred object of the present invention is an all-in-one cleaning solution, which is capable to remove metal-impurities, able to inhibit the deposition of new contaminations and to stabilize the cleaning solution using optimum treating conditions and especially a chelating agent.

A further object of the present invention is a chelating agent used to trap metal impurities in the cleaning solution as stable water-complexes which does not consist of specific groups containing critical elements, especially phosphorus.

In summary, the present invention provides a cleaning solution containing aqueous hydrogen peroxide stabilised against decomposition. Said cleaning solution comprises a mixture of ammonia, hydrogen peroxide, DI-water and at least one chelating agent.

Said complexing agents are used as metal deposition preventive and stabilising compounds. These compounds are 2, 2-Bis-(hydroxyethyl)-(iminotris)-(hydroxymethyl)methan [Bis Tris] or 2, 2-Bis-(hydroxyethyl)-(iminotris)-(hydroxymethyl)methan and nitrilotriacetic acid [NTA; CAS 139-13-9]. 2, 2-Bis-(hydroxyethyl)-(iminotris)-(hydroxymethyl)methan is added alone or in combination with the other to the cleaning compositions.

A suitable cleaning composition may contain these complexing agents in an amount of less than 4000 ppm. Preferably Bis Tris may be added in the range of 1000 - 3000 ppm and NTA in a range of 100- 2000 ppm, most preferably Bis Tris is added in a range less than 2000 ppm and NTA in a range less than 500 ppm. The total weight concentration of said chelating agents preferably should be less than 2000 ppm (0,2 w%), but depending of the case, it may be necessary to add more or to support the cleaning solution during the cleaning process with additional chelating agent.

In general, the cleaning solutions are used at elevated temperatures. Known cleaning solutions are effective at temperatures higher than 60 °C. Mixtures of the present invention advantageously may be used and are effective at temperatures in the range of 20 - 80°C, especially at normal room temperature. Most preferably they are used at temperatures in the range of 40- 50 °C. Depending on the process step the mixtures according to the invention may be brought into contact with surfaces to be cleaned for about a few seconds to 60 minutes, preferably for about 15 seconds to 15 minutes, most preferably for about 30 seconds to 6 minutes,

In order to find an optimised composition for the new cleaning solutions a series of experiments was carried out and the cleaning performance of chelating agents in SC-1 and SC-2 solutions were tested.

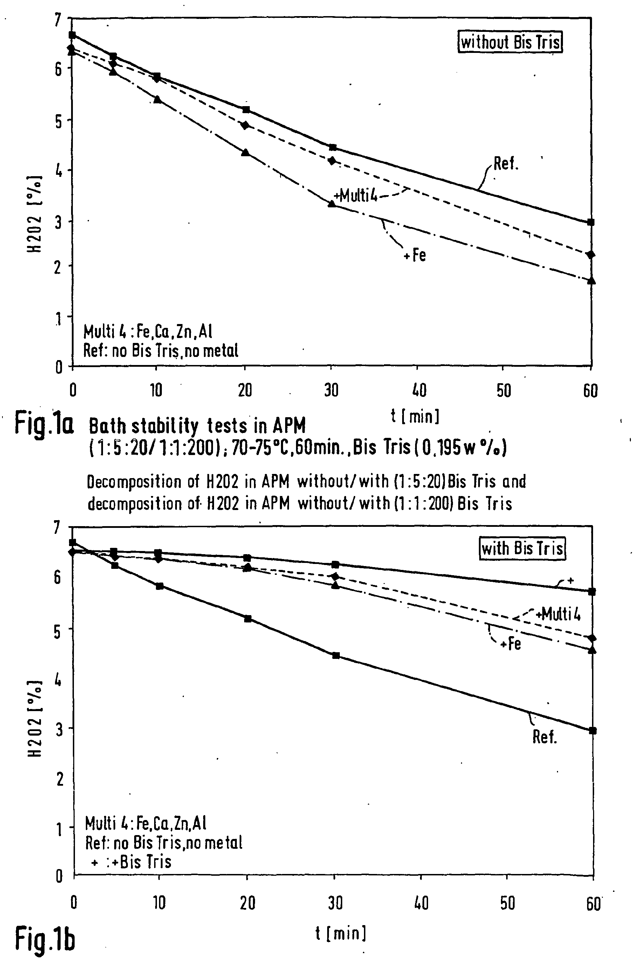

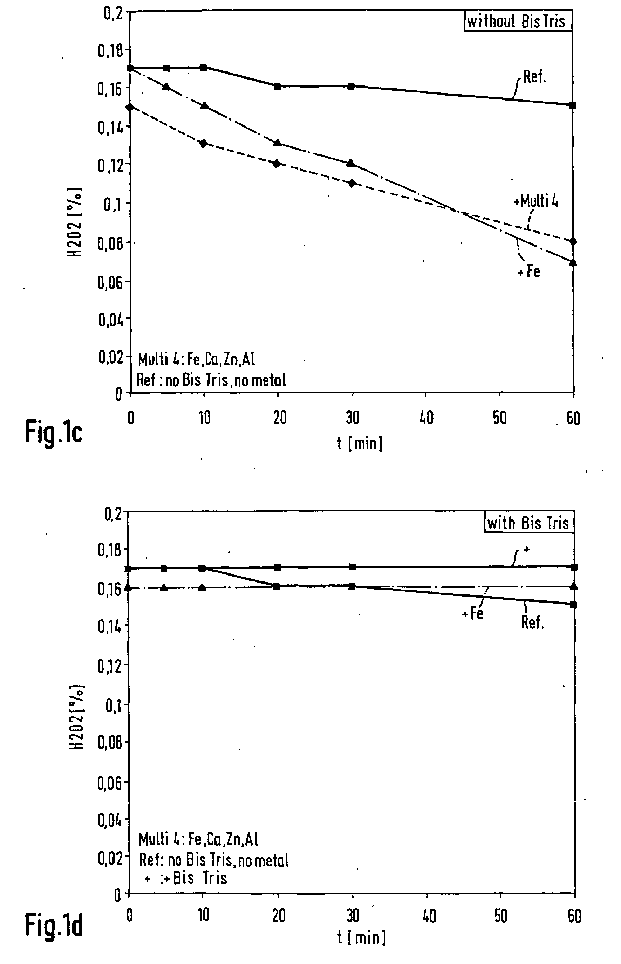

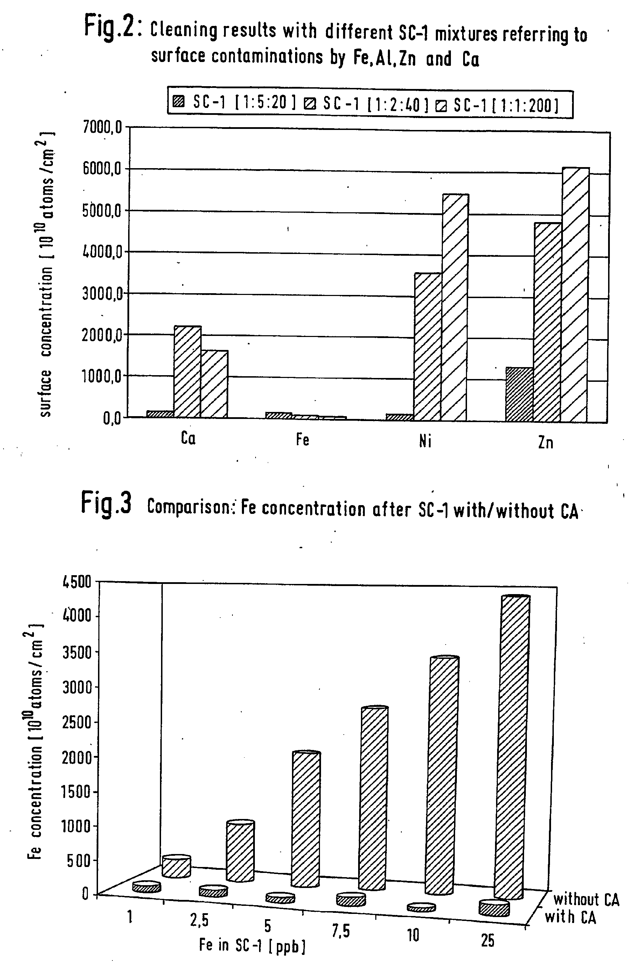

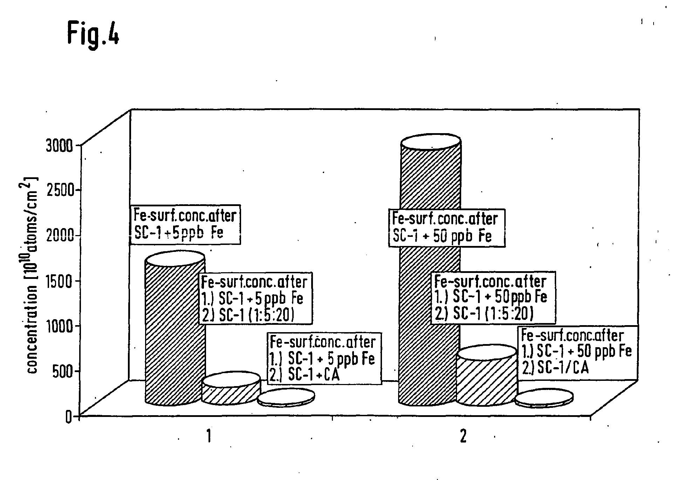

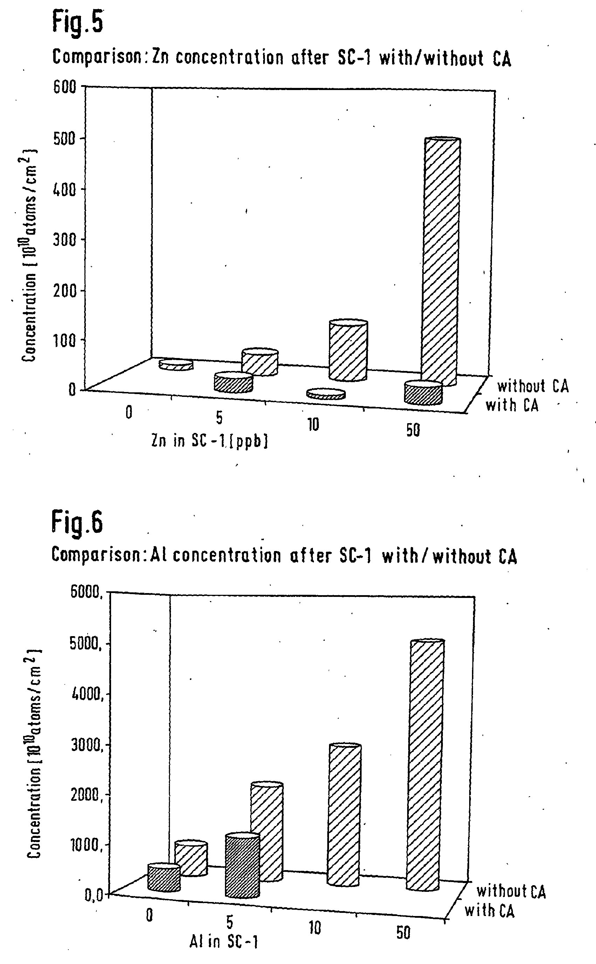

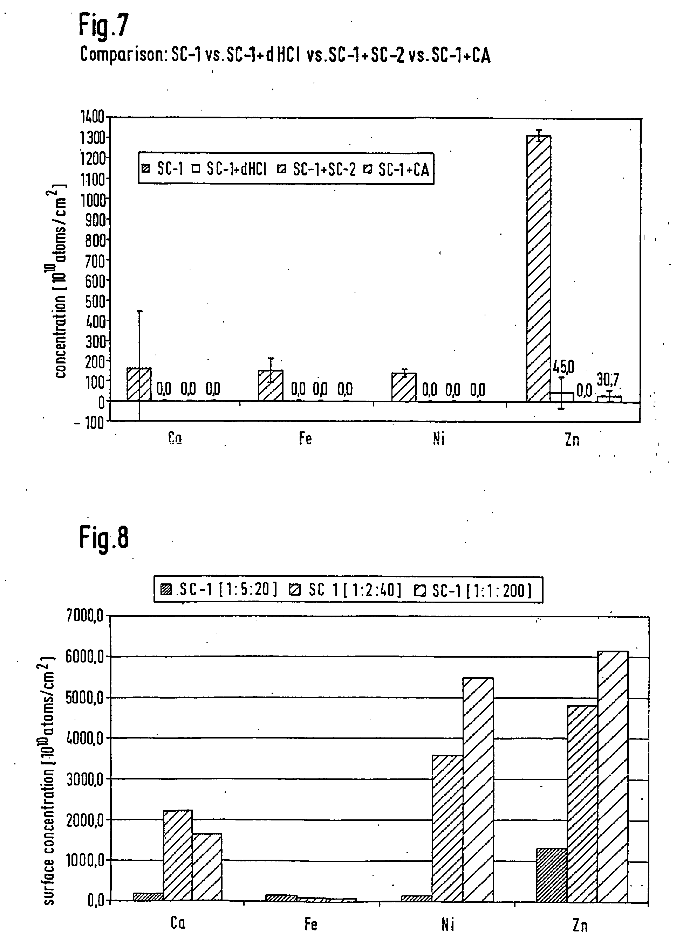

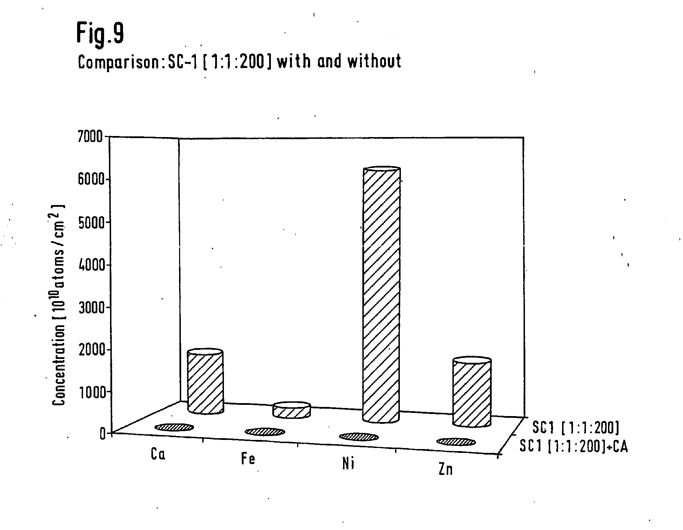

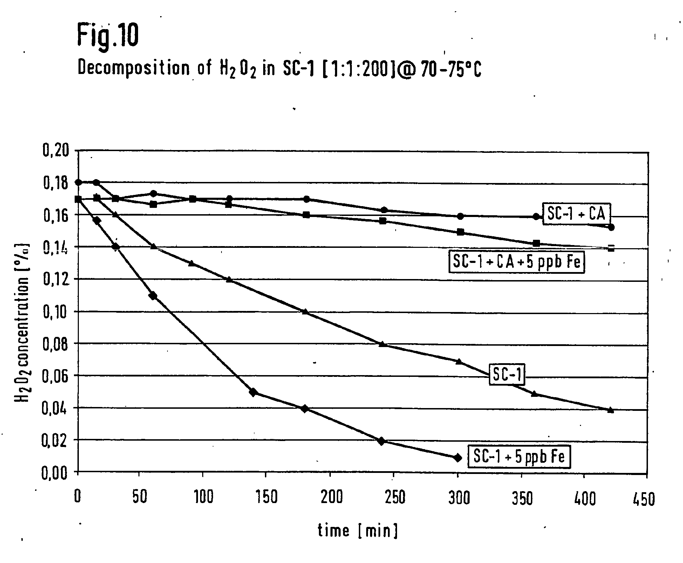

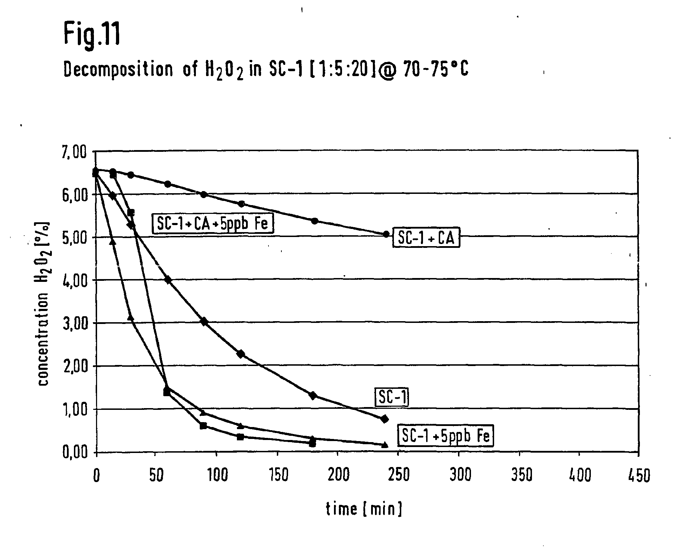

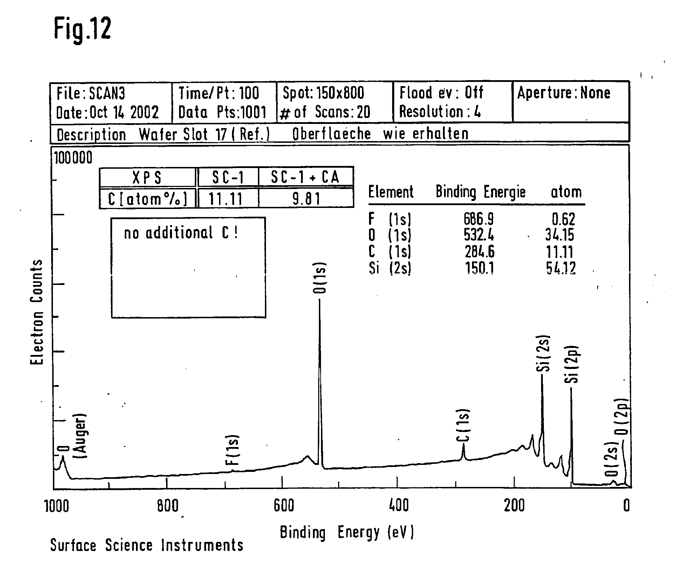

Monitoring the decomposition of H₂O₂ forced by metallic additives exhibits the efficiency of chelating agents in cleaning solutions. Bath stability tests were carried out in APM solutions intentionally spiked with different metals of interest (Fe, Ca, Zn, Al, 5ppb) with / without chelating agent added (Fig. 1).

In further experiments the efficiency of chelating agents for the inhibition of the deposition of metals onto silicon surfaces was monitored. Si-substrates were pre-cleaned by SC-1 and immersed in above mentioned spiked solutions. The metal surface contamination on silicon substrates was analyzed by Total Reflection X-Ray Fluorescence Spectroscopy (TXRF) (**Table 1**).

In addition the removal efficiency of chelating agent from silicon surfaces in SC-1 solutions was studied by TXRF. Si-substrate were pre-contaminated (Fe, Ca, Zn, Al, 10¹²-10¹³at/cm²) and immersed afterwards into SC-1 solutions containing chelating agent (**Table 2**).

The amount of a complexing agent, which has to be added as a metal deposition preventive, depends on the kind and amount of metal impurities a liquid medium contains and of which the deposition is prevented. Also it depends on the cleaning level demanded for a substrate surface. The total amount to be added in a surface treatment composition is generally in the maximum range up to 2 wt %, but usually up to 0.4 wt %. If the above amount is too small, the aimed metal deposition preventive effect of the present invention is hardly achieved. On the other hand, if the above amount is too large, there cannot be achieved any further effect and there is a fear that the complexing agent as a metal deposition preventive tends to be unfavourably deposited on a substrate surface. Using Bis Tris and NTA the latter never has been found.

Examples of a liquid medium used as the main component for a surface treatment composition of the present invention include generally highly purified water, electrolyzed ionic water, an organic solvent or an aqueous solution having an acid, an alkali an oxidizing agent, a reducing agent, a surfactant or the like dissolved, or their mixture solutions. Particularly when an alkaline aqueous solution or a dilute hydrofluoric acid solution is used for cleaning or etching a semiconductor substrate, metal impurities in the solution are very easily deposited on a substrate surface, and therefore in such cases it is preferable to use these solutions by adding a complexing agent in accordance with the present invention.

In the present invention, the alkaline aqueous solution having a pH value of higher than 7. Examples of an alkaline component in this aqueous solution are not especially limited, but typically include ammonia. Also other usable examples include ammonium hydrogen carbonate, or quaternary ammonium salt hydroxides such as tetramethylammonium hydroxide (TMAM), and trimethyl-2-hydroxyethylammonium hydroxide, and the like. These compounds may be added as such or in a mixture of two or more, and the total concentration of the total solution of surface treament composition may be adjusted to 0,001 to 30 wt%. Most preferably ammonia is used. According to the invention preferably it's concentration is adjusted in the range of 0,01 to 10 wt %, more preferable in the range of 0,1 to 8 wt % and most preferably in the range of 0,2 to 4 wt%.

Also, alkali electrolyzed ionic water obtained by electrolysis of water is preferably used. Further, to such an alkaline aqueous solution, hydrogen peroxide as an oxidizing agent is added.

In a cleaning step of semiconductor wafer, when cleaning bare silicon (having no oxidized film), it is possible to control etching or surface roughening of the wafer by incorporating an oxidizing agent. In case of hydrogen peroxide the concentration is generally adjusted within the concentration range of from 0,01 to 30 wt%. When an oxidizing agent is used, the oxidizing agent concentration is preferably adjusted to from 0,1 wt % to 25 wt %. If the amount of oxidizing agent is too large, a complexing agent will be decomposed, and the stability of the surface treatment composition tends to become poor. Particularly, when hydrogen peroxide is used as the oxidizing agent, the hydrogen peroxide concentration is preferably in the range from 0,3 wt % to 22 wt %.

In a preferred treating solution the ratio of the cleaning mixture in view of water, hydrogen peroxide, and ammonia is about 20 : 5 : 1 to about 200 : 1 : 1 (H₂O : H₂O₂ :NH₄OH).

The method for blending the complexing agent of the present invention with a surface treatment composition is not especially limited. The complexing agent may be blended previously with one or more components of the components constituting a surface treatment composition and then these components may be mixed. Alternatively, the complexing agent may be blended with a mixture solution obtained after mixing the components.

In case of SC-1 cleaning, surface treatment is carried out with a composition of (ammonia + hydrogen peroxide + water + metal deposition preventive), but when the surface treatment composition is used for a long time, ammonia is evaporated and the metal deposition preventive is gradually decomposed, thereby degrading the metal deposition preventive effect. Therefore, when the evaporated ammonia content is supplied, the supplement is conducted preferably with an aqueous ammonia containing a metal deposition preventive in an amount of from 10⁻⁷ to 5 wt %, preferably from 10⁻⁶ to 1 wt %. The surface treatment composition of the present invention is used for surface treatment operations including cleaning, etching, polishing, film-forming and the like, for substrates such as semiconductor, metal, glass, ceramics, plastic, magnetic material, superconductor and the like, the metal impurity contamination of which becomes troublesome. The present invention is preferably applied particularly to cleaning or etching of a semiconductor substrate, the surface of which is demanded to be highly clean. Among the cleaning operations of semiconductor substrate, when the present invention is applied particularly to alkali cleaning with a cleaning solution comprising (ammonia, hydrogen peroxide and water), the problem of said cleaning method, i. e. the problem of metal impurity deposition on a substrate can be solved, and by this cleaning, there can be satisfactorily provided a highly clean substrate surface without being contaminated with particles, organic materials and metals.

The reason why the surface treatment composition of the present invention achieves a very satisfactory effect of preventing deposition of metal impurities, is not cleared up to now.

When the surface treatment composition of the present invention is used as a cleaning solution for cleaning a substrate, a method of bringing the cleansing solution directly into contact with the substrate is employed. Examples of such a cleaning method includes dipping type cleaning wherein a substrate is dipped in the cleaning solution in a cleaning tank, spraying type cleaning wherein the cleaning solution is sprayed on a substrate, spinning type cleaning wherein the cleaning solution is dropped on a substrate rotated at a high speed, and the like. In the present invention, among the above-mentioned cleaning methods, it depends on the object which method is suitable and therefore is employed; but the dipping type cleaning method is preferred. The cleaning is carried out for a suitable time, preferably from some seconds to 15 minutes. If the cleaning time is too short, the cleaning effect is not satisfactory. On the other hand, if the cleaning time is too long, it is meaningless since the throughput becomes poor and the cleaning effect is not raised any further.

As already mentioned, advantageously the cleaning may carried out at normal temperature, but it may be carried out at an elevated temperature in order to improve the cleaning effect. Also, the cleaning may be carried out in combination with a cleaning method employing a physical force. Examples for the cleaning method employing a physical force include ultrasonic cleaning, mechanical cleaning employing a cleaning brush, and the like.

In the present invention, in the preparation of a surface treatment composition, a complexing agent sometimes may become a metal contamination source. An ordinary reagent for the complexing agent may contain metal impurities such as Fe in an amount of from several to several thousands ppm. These metal impurities may be present as stable complexes with the complexing agent at the initial stage, but when the complexing agent is used as a surface treatment solution for a long time, the complexing agent may be decomposed and metals may be set free and may be deposited on the substrate surface. Therefore, long time experiments were proceeded using cleaning solutions according to the present invention in order to estimate the deposition of metals like Fe, al, Ca or Al.

These Experiments have shown that a metal deposition preventive effect on a substrate surface was maintained even after a surface treatment solution was allowed to stand at elevated temperature for a long time, whereas conventional compositions led to an increased deposition amount of metal during this experiments.

### Industrial applicability

The surface treatment composition of the present invention containing specific complexing agents, this means Bis Tris and/or NTA, as metal deposition preventives, prevent a substrate surface from being contaminated with metal impurities such as Fe, Al, Zn and Ca from the surface treatment composition, and stably provides an extremely clean substrate surface. Additionally, the addition of these Bis Tris and/or NTA increases the life-time of surface treatment composition decisively.

Particularly, when the present invention is applied to alkali cleaning of a semiconductor substrate represented by "ammonia + hydrogen peroxide + water" cleaning, this means the addition of BisTris or NTA alone or both in combination as described above, a conventional problem of this cleaning is solved, and a highly clean substrate surface can be provided by this cleaning without being contaminated with particles, organic materials and metals. Thus, conventionally employed acid cleaning such as "hydrochloric acid + hydrogen peroxide + water" cleaning conducted after this cleaning can be omitted, and it is therefore possible to largely reduce the cleaning cost, a clean room cost including an exhauster equipment and the like, thus being largely advantageous in industrial production of semiconductor integrated circuits.

Now, the present invention will be described in further detail with reference to Examples. However, it should be understood that the present invention is not limited to such specific Examples within the scope of the subject matter of the present invention.

### Examples

### Example 1

The bathstability of SC-1 solution containing complexant was tested. Monitoring of the decomposition of H₂O₂ forced by metallic additives exhibit the efficiency of chelating agents in cleaning solutions. Bath stability tests were carried out in SC-1 (APM) solutions with two different ratios of volume ( NH40H 28% / H₂O₂ 31% / DI-H₂O, 1-5-20 and 1-1-200). The SC-1 cleaning solutions intentionally spiked with 5ppb of Fe or multi element standard (Fe+Zn+Ca+Al, each element 5ppb) are used at a temperature of 70-75°C for about 60 minutes. The initial concentration of the chelating agent was 0,195w% (Fig. 1).

### Example 2

In further experiments the efficiency of chelating agents to inhibit the deposition of metals onto silicon surfaces was monitored. Si-substrates were precleand by SC-1 (1-5-20, 70-75°C, 10 minutes) and immersed in above mentioned spiked solutions for 10 minutes (1-5-20, 70-75°C). The contamination solution spiked with different amounts of Fe (1-100ppb) was carried out without stirring. In additon the substrates were rinsed with DI-water (5 minutes) and subsequently blown dry with N2. The initial concentration of the chelating agent was 0,195w%. Metal surface contamination on silicon substrates was analyzed by Total Reflection X-Ray Fluorescence Spectroscopy (TXRF) (Table 1).

### Efficiency of Bis Tris to inhibit the deposition of metals onto silicon surfaces

**Tab. 1: Adsorption studies of Fe on silicon surfaces in APM (1-5-20) containing Bis Tris; 70-75°C, 10min. (Ref.: surface conc. without Bis Tris)**

| **Bis Tris [ppm]** | **Fe in APM [ppb]** | | | | |
|---|---|---|---|---|---|
| | **1** | **5** | **10** | **50** | **100** |
| **Ref., [0]** | 2.8 | 20 | 35 | 44 | 36 |
| **After APM, [1950]** | 1.5 | 1 | <1 | 3 | 5 |
| **Cleaning factor** | 1.9 | 20 | 35 | 14 | 7 |

| | | | | | |
|---|---|---|---|---|---|
| surface conc. [1012 at/cm²] by TXRF | | | | | |

### Example 3

In addition the removal efficiency of chelating agent from silicon surfaces in SC-1 solution was studied by TXRF. Si-substrate were pre-contaminated under SC-1 condition (1-5-20, 70-75°C, 10 minutes) containing different amounts of Fe (5ppb, 50ppb). The contaminated substrates were immersed afterwards into Sic-1 solution (1-5-20, 70-75°C, 10 minutes) containing a chelating agent. The initial concentration of the chelating agent was 0,195w% (Table 2).

### Concentration of Fe on silicon surfaces in SC-1

**Tab. 2: Removal efficiency of chelating Bis Tris; 70 - 75°C, 10 min.**

| **Bis Tris [ppm]** | **Fe on Si-Substrat [10¹² at/cm²]** | | | |
|---|---|---|---|---|
| | **5ppb in SC-1** | | **50ppb in SC-1** | |
| | before SC-1 | after SC-1 | before SC-1 | after SC-1 |
| **[1950]** | ~14 | ~1 | ~27 | ~DL* |
| **Removal factor** | ~14 | | ~27-54* | |

| | | | | |
|---|---|---|---|---|
| *DL, Detection Limit (5x10¹¹ at/cm²) of | | | | |

## Claims

1. A cleaning solution for surface treatment operations in which metal impurity contamination becomes troublesome comprising an alkaline compound, hydrogen peroxide, water and 2,2-Bis-(hydroxyethyl)-(iminotris)-(hydroxymethyl)methan or 2,2-Bis-(hydroxyethyl)-(iminotris)-(hydroxymethyl)methan and nitrilotriacetic acid as chelating additive(s).

2. A cleaning solution according to claim 1, **characterised in that** the alkaline compound is chosen from the group consisting of organic base, ammonia, ammonium hydroxide, tetramethyl ammonium hydroxide.

3. A cleaning solution according to claim 1, **characterised in that** the alkaline compound is chosen from the group consisting of ammonia and ammonium hydroxide.

4. A cleaning solution according to claims 1 to 3, comprising 2,2-Bis-(hydroxyethyl)-(iminotris)-(hydroxymethyl)methan in an amount in the range of 1000 to 3000 ppm.

5. A cleaning solution according to claims 1 to 3, comprising nitrilotriacetic acid in an amount in the range of 100 to 2000 ppm.

6. A cleaning solution according to claims 1 to 3, comprising 2,2-Bis-(hydroxyethyl)- (iminotris)-(hydroxymethyl)methan and nitrilotriacetic acid in a total amount less than 4000 ppm.

7. A cleaning solution according to claims 1 to 3, comprising 2,2-Bis-(hydroxyethy1)-(iminotris)-(hydroxymethyl)methan and nitrilotriacetic acid in a total amount less than 2000 ppm.

8. A method for cleaning semiconductor substrate(s) comprising the step of treatment of the semiconductor substrate(s) with a cleaning solution according to one or more claims 1 to 7, and drying said semiconductor substrate(s) after water rinsing.

9. A method of treatment according to claim 8, **characterised in that** the treatment with cleaning solution is carried out at a temperature in the range of 20 to 80°C.

10. A method of treatment according to claim 8, **characterised in that** the treatment with cleaning solution is carried out at normal room temperature.

11. A method of treatment according to claim 8, **characterised in that** cleaning solutions according to claims 1 to 7 are brought into contact with surfaces to be cleaned for a few seconds to 60 minutes.

12. A method of treatment according to claim 8, **characterised in that** cleaning solutions according to claims 1 to 7 are brought into contact with surfaces to be cleaned for about 15 seconds to 15 minutes.

13. A method for treatment of semiconductor substrate(s) according to claims 8 to 12, wherein the semi-conductor substrate(s) is (are) immersed / dipped in the cleaning solution (called dipping type cleaning).

14. Use of cleaning solutions according to claims 1 to 7 for surface treatment operations including cleaning, etching, polishing, film-forming, for the cleaning of substrates such as semiconductor, metal, glass, ceramics, plastic, magnetic material, superconductors.

## Patentansprüche

1. Reinigungslösung für Oberflächenbehandlungsvorgänge, bei denen Metallverunreinigungskontamination störend wird, umfassend eine alkalische Verbindung, Wasserstoffperoxid, Wasser und 2,2-Bis-(hydroxyethyl)-(iminotris)-(hydroxymethyl)-methan oder 2,2-Bis-(hydroxyethyl)-(iminotris)-(hydroxymethyl)methan und Nitrilotriessigsäure als chelatbildendes Additiv bzw. chelatbildende Additive.

2. Reinigungslösung nach Anspruch 1, **dadurch gekennzeichnet, daß** die alkalische Verbindung aus der Gruppe bestehend aus organischer Base, Ammoniak, Ammoniumhydroxid und Tetramethylammoniumhydroxid ausgewählt ist.

3. Reinigungslösung nach Anspruch 1, **dadurch gekennzeichnet, daß** die alkalische Verbindung aus der Gruppe bestehend aus Ammoniak und Ammoniumhydroxid ausgewählt ist.

4. Reinigungslösung nach den Ansprüchen 1 bis 3, umfassend 2,2-Bis-(hydroxyethyl)-(iminotris)-(hydroxymethyl)methan in einer Menge im Bereich von 1000 bis 3000 ppm.

5. Reinigungslösung nach den Ansprüchen 1 bis 3, umfassend Nitrilotriessigsäure in einer Menge im Bereich von 100 bis 2000 ppm.

6. Reinigungslösung nach den Ansprüchen 1 bis 3, umfassend 2,2-Bis-(hydroxyethyl)-(iminotris)-(hydroxymethyl)methan und Nitrilotriessigsäure in einer Gesamtmenge von weniger als 4000 ppm.

7. Reinigungslösung nach den Ansprüchen 1 bis 3, umfassend 2,2-Bis-(hydroxyethyl)-(iminotris)-(hydroxymethyl)methan und Nitrilotriessigsäure in einer Gesamtmenge von weniger als 2000 ppm.

8. Verfahren zum Reinigen eines oder mehrerer Halbleitersubstrate, bei dem man das Halbleitersubstrat bzw. die Halbleitersubstrate mit einer Reinigungslösung nach einem oder mehreren der Ansprüche 1 bis 7 behandelt und das Halbleitersubstrat bzw. die Halbleitersubstrate nach Spülen mit Wasser trocknet.

9. Behandlungsverfahren nach Anspruch 8, **dadurch gekennzeichnet, daß** man die Behandlung mit Reinigungslösung bei einer Temperatur im Bereich von 20 bis 80°C durchführt.

10. Behandlungsverfahren nach Anspruch 8, **dadurch gekennzeichnet, daß** man die Behandlung mit Reinigungslösung bei normaler Raumtemperatur durchführt.

11. Behandlungsverfahren nach Anspruch 8, **dadurch gekennzeichnet, daß** man die Reinigungslösungen nach den Ansprüchen 1 bis 7 über einen Zeitraum von wenigen Sekunden bis 60 Minuten mit zu reinigenden Oberflächen in Berührung bringt.

12. Behandlungsverfahren nach Anspruch 8, **dadurch gekennzeichnet, daß** man die Reinigungslösungen nach den Ansprüchen 1 bis 7 über einen Zeitraum von etwa 15 Sekunden bis 15 Minuten mit zu reinigenden Oberflächen in Berührung bringt.

13. Verfahren zur Behandlung eines oder mehrerer Halbleitersubstrate nach den Ansprüchen 8 bis 12, bei dem man das Halbleitersubstrat bzw. die Halbleitersubstrate in die Reinigungslösung eintaucht/taucht (sogenannte Tauchreinigung).

14. Verwendung von Renigungslösungen nach den Ansprüchen 1 bis 7 für Oberflächenbehandlungsvorgänge einschließlich Reinigen, Ätzen, Polieren, Filmbilden, zum Reinigen von Substraten wie Halbleitern, Metall, Glas, Keramik, Kunststoff, magnetischem Material und Supraleitern.

## Revendications

1. Solution de nettoyage pour des opérations de traitement de surface dans lesquelles la contamination par une impureté métallique devient gênante comprenant un composé alcalin, du peroxyde d'hydrogène, de l'eau et du 2,2-bis(hydroxyéthyl)iminotris(hydroxyméthyl)méthane ou du 2,2-bis(hydroxyéthyl)iminotris-(hydroxyméthyl)méthane et de l'acide nitrilotriacétique comme additif ou additifs chélates.

2. Solution de nettoyage selon la revendication 1, **caractérisée en ce que** le composé alcalin est choisi parmi une base organique, l'ammoniac, l'hydroxyde d'ammonium et l'hydroxyde de tétraméthylammonium.

3. Solution de nettoyage selon la revendication 1, **caractérisée en ce que** le composé alcalin est choisi entre l'ammoniac et l'hydroxyde d'ammonium.

4. Solution de nettoyage selon les revendications 1 à 3, comprenant du 2,2-bis(hydroxyéthyl)iminotris-(hydroxyméthyl)méthane en une quantité dans la plage de 1 000 à 3 000 ppm.

5. Solution de nettoyage selon les revendications 1 à 3, comprenant de l'acide nitrilotriacétique en une quantité dans la plage de 100 à 2 000 ppm.

6. Solution de nettoyage selon les revendications 1 à 3, comprenant du 2,2-bis(hydroxyéthyl)iminotris-(hydroxyméthyl)méthane et de l'acide nitrilotriacétique en une quantité totale inférieure à 4 000 ppm.

7. Solution de nettoyage selon les revendications 1 à 3, comprenant du 2,2-bis(hydroxyéthyl)iminotris-(hydroxyméthyl)méthane et de l'acide nitrilotriacétique en une quantité totale inférieure à 2 000 ppm.

8. Procédé pour le nettoyage d'un ou plusieurs substrats semi-conducteurs comprenant l'étape de traitement du ou des substrats semi-conducteurs avec une solution de nettoyage selon une ou plusieurs des revendications 1 à 7 et le séchage dudit ou desdits substrats semi-conducteurs après rinçage à l'eau.

9. Procédé de traitement selon la revendication 8, **caractérisé en ce que** le traitement avec la solution de nettoyage est effectué à une température dans la plage de 20 à 80°C.

10. Procédé de traitement selon la revendication 8, **caractérisé en ce que** le traitement avec la solution de nettoyage est effectué à température ambiante normale.

11. Procédé de traitement selon la revendication 8, **caractérisé en ce que** des solutions de nettoyage selon les revendications 1 à 7 sont mises en contact avec des surfaces devant être nettoyées pendant une durée de quelques secondes à 60 minutes.

12. Procédé de traitement selon la revendication 8, **caractérisé en ce que** des solutions de nettoyage selon les revendications 1 à 7 sont mises en contact avec des surfaces devant être nettoyées pendant une durée d'environ 15 secondes à 15 minutes.

13. Procédé pour le traitement d'un ou plusieurs substrats semi-conducteurs selon les revendications 8 à 12, dans lequel le ou les substrats semi-conducteurs sont immergés/trempés dans la solution de nettoyage (ce qu'on appelle un nettoyage de type par immersion).

14. Utilisation de solutions de nettoyage selon les revendications 1 à 7 pour des opérations de traitement surface comprenant le nettoyage, le décapage, le polissage et la formation de films, pour le nettoyage de substrats tels qu'un semi-conducteur, du métal, du verre, de la céramique, du plastique, un matériau magnétique et des supraconducteurs.
